(19) Europäisches Patentamt
European Patent Office
Office européen des brevets

(11) **EP 3 542 479 B1**

(12) **EUROPÄISCHE PATENTSCHRIFT**

(45) Veröffentlichungstag und Bekanntmachung des Hinweises auf die Patenterteilung:
**01.12.2021   Patentblatt 2021/48**

(21) Anmeldenummer: **17790675.7**

(22) Anmeldetag: **24.10.2017**

(51) Int Cl.:
*H04L 1/00* (2006.01)    *H04L 1/08* (2006.01)
*H04L 1/20* (2006.01)

(86) Internationale Anmeldenummer:
**PCT/EP2017/001245**

(87) Internationale Veröffentlichungsnummer:
**WO 2018/091126 (24.05.2018 Gazette 2018/21)**

(54) **VERFAHREN UND EINRICHTUNG ZUM SENDEN HAUSTECHNISCHER DATEN**

METHOD AND DEVICE FOR TRANSMITTING DOMESTIC DATA

PROCÉDÉ ET DISPOSITIF D'ÉMISSION DE DONNÉES DU BÂTIMENT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **16.11.2016   DE 102016013653**

(43) Veröffentlichungstag der Anmeldung:
**25.09.2019   Patentblatt 2019/39**

(73) Patentinhaber: **Diehl Metering Systems GmbH**
**90451 Nürnberg (DE)**

(72) Erfinder:
• **PETKOV, Hristo**
**90425 Nürnberg (DE)**

• **LAUTENBACHER, Thomas**
**91058 Erlangen (DE)**
• **KAUPPERT, Thomas**
**90455 Nürnberg (DE)**
• **GOTTSCHALK, Klaus**
**90610 Winkelhaid (DE)**

(74) Vertreter: **Diehl Patentabteilung**
**c/o Diehl Stiftung & Co. KG**
**Stephanstraße 49**
**90478 Nürnberg (DE)**

(56) Entgegenhaltungen:
**WO-A1-2015/113664       US-A1- 2012 263 107**
**US-A1- 2015 373 683       US-A1- 2016 262 109**

## Beschreibung

Die vorliegende Erfindung betrifft ein Verfahren zum wiederholten Senden haustechnischer Daten sowie eine Einrichtung zum Ausüben des erfindungsgemäßen Verfahrens.

In der EP 2 953 275 A1 ist ein Funkübertragungssystem beschrieben, bei dem eine Datenquelle eine Aufeinanderfolge von Verbrauchsmesswerten sensorisch erfasst. Der jeweilige digitalisierte Messwerte- bzw. Metering-Datensatz aus Messwert, Quellenidentifikation und Übermittlungszusätzen wird von dieser Datenquelle aus per bidirektionalem Nahbereichs-Datenfunk Downlink in Form eines herkunftsbezogen kodierten Datentelegrammes an einen abgesetzt betriebenen Speicher übermittelt. Das Datentelegramm wird auch als Paket oder Datenpaket bezeichnet, und der Speicher samt Datenverarbeitung auch als Konzentrator. Umgekehrt können Uplink Informationen wie Tarifwechsel-Vorgaben vom Speicher an Datenquellen übermittelt und dort ausgewertet werden. Aus dem Speicher können die von mehreren Datenquellen stammenden Datentelegramme, selektiv zwischengespeichert und gegebenenfalls vorverarbeitet, über Weitbereichsfunk etwa im Mobilfunkstandard abgerufen und direkt per Funk oder mittels eines Speichermediums an eine Zentralstelle übermittelt werden, in der die Daten beispielsweise zum Erstellen von Verbrauchsabrechnungen ausgewertet werden.

Bei den Messwerten bzw. bidirektional übertragbaren Daten kann es sich z. B. um den Verbrauch an Kalt- und Warmwasser, Gas, Wärme oder Elektrizität handeln, der gewöhnlich von Sensoren vor Ort auf Zähler-Basis ermittelt wird. Ferner kann es sich bei den bidirektional übertragbaren Daten auch um andere haustechnische und fernwirktechnische Variablen (insbesondere Soll- und Istwerte), wie die Temperatur in einem Raum oder die Winkelstellung einer Lüftungsklappe handeln.

Die Datentelegramme können komplett oder in Teiltelegramme bzw. Teildatenpakete zerlegt übertragen - und in diesem Falle empfangsseitig wieder zu kompletten Datentelegrammen zusammengefügt - werden. Derartige Datenübertragungen erfolgen unsynchronisiert in sogenannten Zeitschlitzen, beispielsweise als Frequenzmodulation eines Trägers im VHF-Spektrum, vorzugsweise aber in einem der nicht eigens lizenzierten ISM (Industrial, Scientific and Medical)- und/oder SRD (Short Range Devices)-Bänder des UHF-Spektrums und somit bei a priori unbekannter und variierender momentaner Kanalbelegung. Da es deshalb zu erwarten ist, dass ein beim Speicher empfangenes Datentelegramm während seiner Übermittlung eine Störung erfährt, so dass es im Speicher nicht auszuwerten ist, wird das Datentelegramm vom Sender im Transceiver der Datenquelle an den Empfänger im Transceiver des Speichers in gewissen Abständen wiederholt gesendet; derart, dass zumindest einmal ein störungsfreier Empfang zu erwarten ist.

In der Metering-Technologie muss somit eine gewisse, letztlich durch die Sendewiederholungen überwundene, sogenannte Paketfehlerrate (PER; packet error rate) in Kauf genommen werden, bei der es sich um das Verhältnis der Anzahl an erfolgreich empfangenen Datentelegrammen bzw. Teiltelegrammen zur bekannten Anzahl während dieser Zeitspanne tatsächlich gesendeter Datentelegramme bzw. Teiltelegramme handelt. Andererseits wird für die Datentelegramme (Pakete) eine gewisse Aktualität gefordert, die je nach Daten-Inhalt Minuten oder Stunden bis hin zu Tagen betragen kann; bis dann muss mit hinreichender Wahrscheinlichkeit ein aktuelles, wiederholt gesendetes Datentelegramm trotz Störeinflüssen im Übertragungskanal schließlich korrekt im Speicher erfasst sein. Diese Vorgehensweise lässt ein häufiges Wiederholen der gesendeten Datentelegramme wünschenswert erscheinen. Aber es kann dadurch zu einer unnötigen Belastung des Übertragungskanales führen. Zudem ist eine möglichst geringe Anzahl an Sendewiederholungen anzustreben, um z. B. die Batterie mit ihrer vorgegebenen Funktionsdauer im Sender des Tansceivers der Datenquelle nicht unnötig zu beanspruchen. Deshalb mag es zu Beginn der Batterie-Funktionsdauer noch vertretbar sein, der Steuerung des Senders mindestens eine erfahrungsgemäß auf jeden Fall ausreichende Anzahl von Sendewiederholungen des Datentelegrammes fest vorzugeben, dennoch sollten gegen Ende der kalkulierten Batterie-Funktionsdauer nicht mehr Sendewiederholungen erfolgen, als statistisch für die im Ergebnis korrekte Übermittlung eines aktuellen Datentelegrammes erforderlich sind.

Die WO 2015/113664 A1 offenbart ein drahtloses Telekommunikationssystem, das eine Basisstation umfasst, die angeordnet ist, um Nachrichten an ein oder mehrere Endgeräte über eine Funkschnittstelle zu übertragen. Die Funkschnittstelle weist eine Struktur auf, bei der eine Nachricht unter anderem gemäß einem Übertragungsschema unter Verwendung von Wiederholungsübertragungen übertragen werden kann. Die Nachricht wird in Verbindung mit einem Identifikator übertragen, um eine Endvorrichtung anzuzeigen, an die die Nachricht gerichtet ist. Die Endvorrichtung, an die die Nachricht adressiert ist, bestimmt das Übertragungsschema aus der Eigenschaft des Identifikators und empfängt die Nachricht entsprechend.

In der US 2012/0263107 A1 werden Systeme, Verfahren und Vorrichtungen zur Reichweitenverlängerung für die drahtlose Kommunikation in Sub-Gigahertz-Bändern beschrieben. Unter bestimmten Umständen werden Teile von Paketen zeitlich und/oder örtlich wiederholt, wenn das Paket übertragen wird, um die Wahrscheinlichkeit zu erhöhen, dass das Paket dekodiert werden kann. Die Wiederholung von Teilen des Pakets kann zum Teil auf den Kanaleigenschaften des Kanals basieren, über den das Paket gesendet wird. In einigen Aspekten werden Teile von Paketen über eine kleinere Bandbreite mit erhöhter Leistung pro Frequenzbereich übertragen.

Die US 2015/0373683 A1 offenbart einen Mechanismus zur Verbesserung der Funkabdeckung für eine drahtlose Vorrichtung, der auf einem Austausch von Uplink- und Downlink-Funkzustandsinformationen, den sogenannten Uplink- und Downlink-Radio Coverage Category (RCC)-Werten, zwischen der drahtlosen Vorrichtung und einem Netzwerk zur Verwendung bei der Datenübertragung basiert.

In der US 2016/0262109 A1 werden Verfahren, Systeme und Vorrichtungen zur Sendeleistungssteuerung und Wiederholungsstufen von Direktzugriffsanforderungen in einem drahtlosen Kommunikationsnetzwerk beschrieben. Leistungseinstellungen und Wiederholungsstufen für Übertragungen von Anfragen mit wahlfreiem Zugriff können vorherige Leistungseinstellungen oder vorherige Wiederholungsstufen für den Uplink-Kanal berücksichtigen und/oder darauf basieren. Die Leistungseinstellungen können auch auf anderen Faktoren beruhen, einschließlich eines Leistungshochlaufs im Zusammenhang mit aktuellen oder früheren Zufallszugriffsverfahren. Leistungseinstellungen können von einer Benutzereinrichtung (UE) berechnet oder von einem anderen Systemknoten an eine UE angezeigt werden. Die beschriebenen Merkmale können als Abdeckungserweiterungstechniken implementiert werden.

Der vorliegenden Erfindung liegt in Erkenntnis solcher Gegebenheiten die technische Problemstellung zugrunde, die Anzahl der Sendewiederholungen bis zum jeweiligen ungestörten Vorliegen eines aktuellen Datentelegrammes im Speicher zu optimieren.

Die vorliegende Aufgabe ist mit der in den beiden unabhängigen Patentansprüchen jeweils angegebenen Merkmalskombination gelöst. Demnach wird beim Speicher quasi- oder diskontinuierlich die momentane Paketfehlerrate (im Sinne des Verhältnisses zwischen erfolgreich empfangenen Datentelegrammen und währenddessen tatsächlich aktuell gesendeten Datentelegrammen) bestimmt. Durch Verändern der Anzahl bzw. der Frequenz der Sendewiederholungen kann für die momentanen Übertragungsgegebenheiten (repräsentiert durch die Anzahl ungestört empfangener Datentelegramme) die Paketfehlerrate auf einen gewünschten Wert eingestellt werden. Diese Wiederholungs-Vorgabe wird vom Speicher im Uplink an die jeweilige Datenquelle übermittelt und im Speicher für die nächstfolgende Bestimmung der aktuellen Paketfehlerrate verfügbar gehalten. Somit werden die wirksamen Übertragungsgegebenheiten durch adaptives Anpassen der Sendewiederholungen für eine anzustrebende Paketfehlerrate konstant gehalten.

Zweckmäßigerweise kann jedes der relativ langen Datentelegramme in als solcher bekannter Weise nicht als Ganzes übertragen, sondern in Form von entsprechend individualisierten, nacheinander gesendeten Teiltelegrammen, die im Speicher wieder zum Gesamt-Datentelegramm gruppiert bzw. zusammengefügt werden, um beim Speicher bzw. Datensammler möglichst rasch wenigstens ein ungestörtes Datentelegramm zu empfangen. Wenn sich dabei herausstellt, dass ein bestimmtes Datentelegramm gestört ist, betrifft die Störung in der Regel tatsächlich nur noch ein bestimmtes, kurzes Teiltelegramm aus diesem Datentelegramm. Gerade dieses Teiltelegramm wird beim nachfolgenden Empfang des wiederholten Datentelegrammes nicht wieder gestört sein, so dass mit Übernahme dieses Teiltelegrammes in das vorangegange gestört empfangene Datentelegramm dort nun ein vollständiges, ungestörtes Datentelegramm rascher zur Verfügung steht, als wenn auf ein wiederholtes, komplett ungestört empfangenes Datentelegramm gewartet werden müsste; mit entsprechender Steigerung des Wertes der Paketfehlerrate, die sich im oben definierten Sinne zwischen den Werten Null und Eins erstreckt.

Die erfindungsgemäße Lösung wird nachstehend, unter Bezugnahme auf die Zeichnungsfiguren näher veranschaulicht, es zeigen:

Fig. 1    eine vereinfachte schematische Darstellung einer Datentelegrammsendung mittels des erfindungsgemäßen Verfahrens, sowie

Fig. 2    eine vereinfachte schematische Darstellung eines Kommunikationssystems, in welchem Datentelegramme anhand des erfindungsgemäßen Verfahrens übermittelt werden.

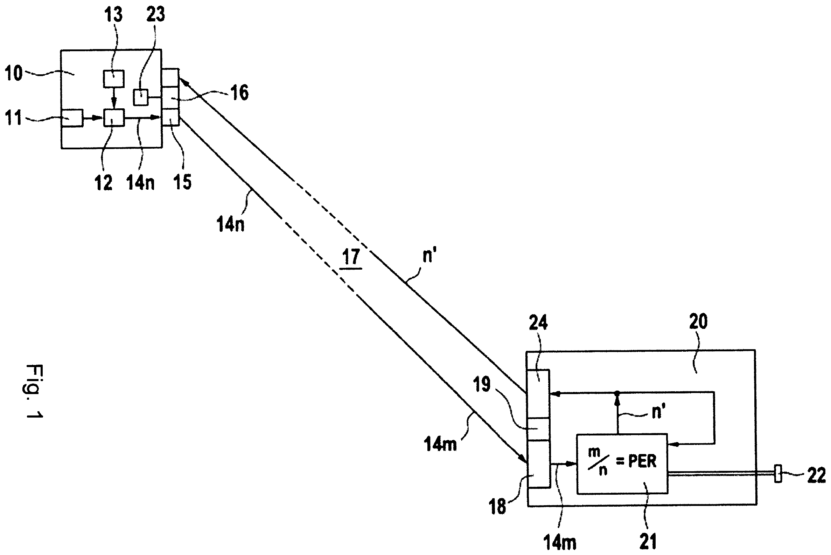

In Fig. 1 werden von mehreren Datenquellen 10i die von einem Sensor 11 gelieferten, gewöhnlich analogen Daten einer AD-Wandlung in einem AD-Wandler 12 unterzogen und mit weiteren Informationen, wie einer Herkunftskennung, einem Zeitstempel, einem Paritätsbit und/oder dergleichen, aus einem Kodierer 13 derart kombiniert, dass sich ein komplettes Datentelegramm 14 zusammensetzt. Das Datentelegramm 14 wird von einem Sender 15 im quellenseitigen Transceiver 16 über eine gewisse Zeitspanne wiederholt, nämlich n-mal, über einen z. B. stochastisch gestörten Übertragungskanal 17 an den Empfänger 18 des Transceivers 19 eines zentralen Speichers 20 übermittelt. Wegen der Störeinflüsse können z. B. nur m<n der wiederholt gesendeten Datentelegramme 14n fehlerfrei, d. h. auswertbar, empfangen werden. Beim Speicher 20 ermittelt ein Vergleicher 21 aus dem Verhältnis m/n der fehlerfrei empfangenen Datentelegramme 14m zur systembekannten Anzahl n tatsächlich über der Zeitspanne wiederholt gesendeter Datentelegramme 14 die Paketfehlerrate PER für die aktuell angetroffenen Übertragungsgegebenheiten auf dem benutzten Übertragungskanal 17. Optimal wäre die in der Praxis tatsächlich nicht erreichbare Paketfehlerrate PER=1 wegen m=n. Zweckmäßigerweise kann der Vergleicher 21 als Vorrichtung innerhalb des Speichers 20 und/oder als reine Softwarelösung bzw. Softwareimplementierung ausgestaltet sein.

Zum Beeinflussen der Paketfehlerrate PER wird vom Vergleicher 21 die Anzahl der künftigen quellseitigen Aussendungen auf n' geändert. In welchem Sinne und wie stark die Änderung ausfallen soll, kann programmgesteuert, ferngesteuert oder direkt beim Speicher 20 über ein Stellglied nach Art einer Handhabe 22 beeinflusst oder vorgegeben werden. Als Handhabe 22 kann beispielsweise eine hardwaretechnische Ansteuerung oder eine reine Softwareimplementierung vorgesehen sein. In der Praxis wird ein trotz variierender Übertragungsgegebenheiten möglichst konstanter, nach Maßgabe der angestrebten Aktualität der übermittelten Datentelegramme vorgebbarer Wert der Paketfehlerrate PER angestrebt. Dieser ist z. B. durch das Variieren der Wiederholungsanzahl n erreichbar bzw. festlegbar.

Bei n'>n in einer vorgegebenen Zeitspanne kann die Wiederholfrequenz für das Aussenden des Datentelegrammes 14 gesteigert werden, d. h. die Paketfehlerrate wird reduziert, und umgekehrt. Jedenfalls gegen Ende der Betriebszeitspanne der Batterie 23 für den Transceiver 16 sollte aber mittels n'<n die Wiederholfrequenz der Aussendungen abgesenkt werden, um die Batterie 23 zu schonen. Die Anzahl der künftigen Sendewiederholungen n' wird vom Sender 24 des speicherseitigen Tansceivers 19 im Uplink an die Steuerung des quellenseitigen Senders 15 übermittelt und zudem für die nächste Bestimmung der Paketfehlerrate PER im Vergleicher 21 vorgehalten.

In der Regel treten in einem frei zugänglichen und entsprechend stark belegten Übertragungskanal 17 Störeinflüsse auf, die sich insbesondere auf die Datentelegramme 14n auswirken, die z. B. von einer Datenquelle 10 unsynchronisiert in Zeitschlitzen an einen Speicher 20 gesendet werden. Infolgedessen muss das jeweilige Datentelegramm 14 mehrmals wiederholt gesendet werden, bis das Datentelegramm 14m wenigstens einmal ungestört empfangen worden ist. Mittels eines Vergleichers 21 wird über eine gewisse Zeitspanne eine Paketfehlerrate PER aus dem Verhältnis der Anzahl m ungestört empfangener zu der Anzahl n währenddessen tatsächlich gesendeter Datentelegramme 14m/14n bestimmt. Im Interesse einer optimierten Datenaktualität der für den Speicher 20 verfügbaren, ungestörten Datentelegramme 14m wird z. B. die Anzahl n' künftiger Sende-Wiederholungen pro Zeiteinheit erhöht, d. h. die Paketfehlerrate PER jener Definition zufolge verringert; und umgekehrt. Auf die Veränderung der Anzahl n => n' künftiger Sende-Wiederholungen zum Erreichen einer bestimmten, vorgegebenen Paketfehlerrate PER unter den aktuellen Übertragungsgegebenheiten kann programmgesteuert, ferngesteuert oder vor Ort manuell Einfluss genommen werden. So ist erfindungsgemäß die Paketfehlerrate PER durch das Anpassen der Sendewiederholungsanzahl n' an die momentanen Übertragungsgegebenheiten adaptiv optimierbar, weil für das Einhalten einer gewünschten Paketfehlerrate PER trotz variierender Übertragungsgegebenheiten eine entsprechende Wiederholungs-Anzahl n' vom Speicher 20 an die Datenquelle 10 vorgegeben wird.

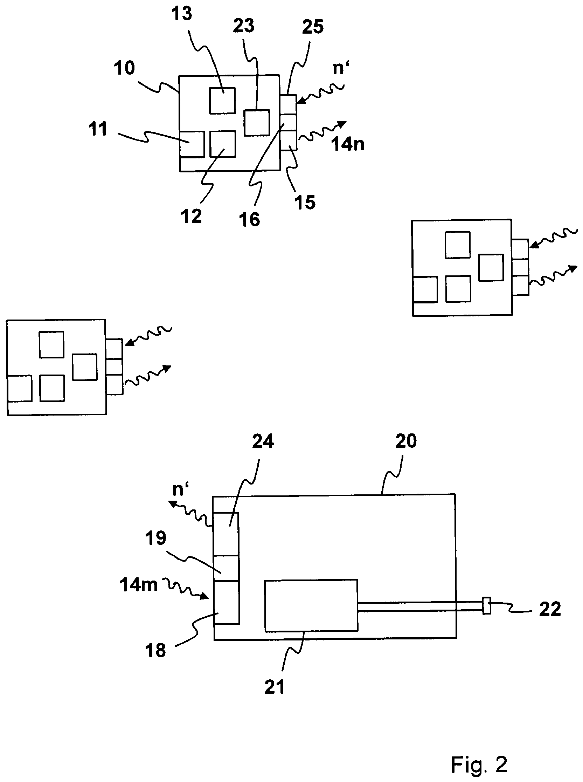

In Fig. 2 ist ein Funkübertragungssystem bzw. Kommunikationssystem dargestellt, welches mehrere Datenquellen 10 und einen Speicher 20 umfasst. Die Datenquellen 10 sind als Verbrauchszähler ausgestaltet, z. B. als Wasser-, Gas-, Wärmemengen- oder Stromzähler, die den aktuellen Verbrauch erfassen und in Form von Verbrauchsdaten an den Speicher 20 übermitteln. Die Datenquellen 10 umfassen jeweils einen Sensor 11 zum Erfassen der Verbrauchsdaten, z. B. einen Ultraschallsensor zum Bestimmen einer Durchflussmenge an einem Verbrauchsmedium (z. B. Wasser oder Gas), sowie einen Transceiver 16 mit Sender 15 zum Senden und/oder Empfangen der Datentelegramme bzw. Teiletelegramme über den Übertragungskanal 17, d. h. ein bidirektionaler Übertragungskanal. Der Speicher 20 ist als Datensammler bzw. Datenkonzentrator mit Transceiver 19 ausgestaltet und dient zum Empfang, Sammeln und/oder Weiterleiten der Daten bzw. Verbrauchsdaten. Eine erfindungsgemäße Einrichtung zum insbesondere wiederholten Senden haustechnischer Daten, wie z. B. die Verbrauchsdaten, umfasst jeweils den Sensor 11 und den Transceiver 16 der Datenquelle 10 sowie den Transceiver 19 des Speichers 20.

Die Verbrauchszähler übertragen die Daten drahtlos an den Datensammler, z. B. per Funk über nicht lizensierte Frequenzbänder, wie die ISM- und/oder SRD-Frequenzbänder. Die Verbrauchszähler umfassen jeweils einen Sender 15, welcher hinsichtlich des Energieverbrauchs bzw. der verfügbaren Energie Einschränkungen bei Sendezeit und Sendedauer einhalten muss, d. h. beispielsweise vom Ladezustand der Batterie 23 abhängig ist. Die Batterie 23 kann hierbei neben der Energieversorgung des Transceivers 16 auch zur Energieversorgung des Sensors 11 vorgesehen sein. Die Verbrauchszähler senden ihre Datentelegramme in regelmäßigen Intervallen, wobei der Datensammler die Daten der Verbrauchszähler empfängt, die sich in Empfangsreichweite befinden.

Aufgrund von Übertragungen über nicht lizensierte Frequenzbänder, ist die Kanalbelegung in der Regel zunächst unbekannt und kann zudem variieren. Dadurch, dass die Kanalbelegung unbekannt ist, kann die erreichbare Datenaktualität schwer vorhergesagt werden. Zur Übertragung wird z. B. ein Verfahren verwendet, bei dem ein Datentelegramm in mehrere Teiletelegramme unterteilt wird, welche mit zeitlichen Pausen gesendet werden (Telegramm Splitting). Die Teiletelegramme werden anschließend im Empfänger, d. h. insbesondere im Datensammler, wieder zusammengefügt.

Bei diesem Verfahren berechnet sich die Wahrscheinlichkeit, dass die Daten aufgrund von Störungen durch Überlagerung mit anderen Signalen in dem Kanal nicht richtig übertragen werden durch die Paketfehlerrate PER, welche aus der Anzahl m erfolgreich vom Empfänger, d. h. dem Speicher 20 bzw. Datensammler, empfangener Datentelegramme und/oder Teiletelegramme zu der Anzahl n der vom Sender, d. h. der Datenquelle 10 bzw. dem jeweiligen Verbrauchszähler, gesendeter Datentelegramme und/oder Teiletelegramme gebildet wird (PER = m/n). Die Wahrscheinlichkeit $p_1$ beschreibt hierbei die Wahrscheinlichkeit, dass ein Teiletelegramm gestört wird und nicht richtig übertragen werden kann:

$$PER = p1^n$$

Die theoretische Herleitung der Paketfehlerrate PER kann dadurch erfolgen, dass z. B. ein Slot bzw. ein Frequenzkanal vollständig verworfen wird, wenn sich ein Störer mit einer bestimmten Zeitdauer t(Störer) auf dem Slot mit der Zeitdauer t(Slot) befindet. Für die Wahrscheinlichkeit p(Slot), dass der Slot gestört ist gilt:

$$p(Slot) = 1 - e^{-[(t(Slot) + t(Störer)) / t(Störer)] \cdot Kanalbelegung}$$

Die Wahrscheinlichkeit p(alle), dass alle Slots belegt sind, errechnet sich demnach über die Anzahl der Slots n(Slots) mit

$$p(alle) = PER = p(Slot)^{n(Slots)}.$$

Vorzugsweise wird beim erfindungsgemäßen Verfahren jedoch die jeweils aktuelle Paketfehlerrate PER(ist) bestimmt. Das Sendeintervall der Verbrauchszähler innerhalb des Kommunikationssystems bekannt und somit auch die Anzahl gesendeter Datentelegramme innerhalb eines bestimmten Zeitraums n(tx). Hierbei wird aus der Anzahl tatsächlich empfangener Datentelegramme n(Rx), d. h. der Anzahl erfolgreich empfangener Datentelegramme am Datensammler, und der bekannten Anzahl gesendeter Datentelegramme die aktuelle Paketfehlerrate PER(ist) bestimmt:

$$PER(ist) = n(Rx) / n(tx)$$

Ferner ist im Kommunikationssystem auch die Anzahl n(ist) aktuell gesendeter Teiltelegramme bekannt, sodass aus der Kenntnis von PER(ist) und n(ist) die aktuelle Wahrscheinlichkeit p(ist) einer Kanalbelegung bzw. Kanalstörung berechnet werden kann:

$$p(ist) = \sqrt[n(ist)]{PER(ist)}$$

Zweckmäßigerweise wird somit eine gewünschte bzw. optimale PER(soll) festgelegt. Für eine optimale PER(soll) wird somit die erforderliche Anzahl an Aussendungen der Teiltelegramme n(soll) kalkuliert:

$$n(soll) = log\,(p(ist)) \cdot PER\,(soll)$$

Anschließend kann über den Rückkanal, d. h. vom Sammler 20 zur Datenquelle 10, der Datenquelle 10 bzw. dem Verbrauchszähler die erforderliche Anzahl an Aussendungen n(soll) mitgeteilt werden, insbesondere zusammen mit dem Befehl die Datentelegramme bzw. Teiltelegramme in der Anzahl n(soll) an einen Empfänger 25 des Transceivers 16 der Datenquelle 10 zu übertragen. Dadurch kann die gewünschte Paketfehlerrate PER(soll) festgelegt bzw. eingestellt werden.

Zusammenfassend kann somit anhand des erfindungsgemäßen Verfahrens die aktuelle Paketfehlerrate PER(ist) durch die Kenntnis der vorgegebenen Aussendungen ermittelt werden. Daraus kann die für die erfolgreiche (im Wesentlichen ungestörte) Sendung der Datentelegramme notwendige Anzahl der Sendungen von Teiltelegrammen bzw. Teilpaketen ermittelt werden, die der Datenquelle 10 mitgeteilt wird, um die Anzahl der Sendungen anzupassen. Demzufolge wird durch das erfindungsgemäße Verfahren eine adaptive Steuerung der Paketfehlerrate PER durch das Anpassen bzw. Beeinflussen der Anzahl gesendeter Datentelegramme bzw. Teiltelegramme verwirklicht. In vorteilhafter Weise kann somit die Anzahl der Sendewiederholungen, bis zum jeweiligen ungestörten Vorliegen eines aktuellen Datentelegrammes im Speicher 20 bzw. Datensammler, trotz der auf dem Übertragungskanal unvermeidbaren variablen Störeinflüsse optimiert werden.

Bezugszeichenliste

10    Datenquelle

11    Sensor
12    AD-Wandler
13    Kodierer
14    Datentelegramm
15    Sender (von 16 bei 10)
16    Transceiver
17    Übertragungskanal
18    Empfänger (von 19 bei 20)
19    Transceiver
20    Speicher
21    Vergleicher
22    Handhabe
23    Batterie (für 15)
24    Sender (von 19 bei 20)
25    Empfänger (von 16 bei 10)

PER    Paketfehlerrate
n    Anzahl
p    Wahrscheinlichkeit
t    Zeitdauer


**Patentansprüche**

1. Verfahren zu wiederholtem Senden haustechnischer Daten als Datentelegramme (14n) von einem Transceiver (16) einer Datenquelle (10) an einen Speicher (20) über einen stochastisch gestörten Übertragungskanal (17) in mindestens einem ISM- und/oder SRD-Band mit a priori unbekannter und variierender momentaner Kanalbelegung, wobei in einem Vergleicher (21) für die über eine Zeitspanne empfangenen Datentelegramme (14m) eine Paketfehlerrate (PER) als das Verhältnis ungestört empfangener zu während der Zeitspanne gesendeter Datentelegramme (14m/14n) bestimmt wird, wobei die momentane Paketfehlerrate PER(ist) quasi- oder diskontinuierlich für die jeweils aktuell angetroffenen Übertragungsgegebenheiten bestimmt wird, wobei die Anzahl (n') künftiger Sende-Wiederholungen zur Beeinflussung der Paketfehlerrate (PER) verändert wird, damit mit hinreichender Wahrscheinlichkeit ein aktuelles, wiederholt gesendetes Datentelegramm (14) trotz Störeinflüssen, wobei es sich bei den Störeinflüssen um Störungen durch Überlagerung mit anderen Signalen in dem Kanal handelt, im Übertragungskanal (17) korrekt im Speicher (20) erfasst wird, wobei die Anzahl (n'), künftiger Sendewiederholungen über den Übertragungskanal (17), im Vergleicher (21) abgelegt und an den Transceiver (16) der Datenquelle (10) übermittelt wird und wobei die Vorgabe einer optimalen bzw. gewünschten Paketfehlerrate PER(soll) durch die Veränderung der Anzahl (n') künftiger SendeWiederholungen erreicht wird, indem die aktuelle Wahrscheinlichkeit p(ist) einer Kanalbelegung bzw. Kanalstörung, welche sich aus der momentanen Paketfehlerrate PER(ist) bestimmt, und die optimale Paketfehlerrate PER(soll) zur Bestimmung der erforderlichen Anzahl an Aussendungen der Datentelegramme bzw. Teiltelegramme n(soll) herangezogen wird.

2. Verfahren nach Anspruch 1, **dadurch gekennzeichnet, dass** eine Batterie (23) zum Betrieb wenigstens des Senders (15) und/oder des Sensors (11) der Datenquelle (10) vorgesehen ist und gegen Ende der Betriebszeitspanne der Batterie (23) die Anzahl (n') beziehungsweise die Frequenz künftiger SendeWiederholungen reduziert wird.

3. Verfahren nach einem der vorangehenden Ansprüche, **dadurch gekennzeichnet, dass** die Anzahl (n') künftiger Sende-Wiederholungen programmgesteuert, ferngesteuert oder manuell beeinflusst wird.

4. Verfahren nach einem der vorangehenden Ansprüche, **dadurch gekennzeichnet, dass** aufeinanderfolgende Datentelegramme (14n) jeweils als Teiltelegramme gesendet und empfangen werden, mit Ersatz eines fehlerhaften Teiltelegrammes durch dasjenige korrekte aus einem der schon wiederholt gesendeten und empfangenen Datentelegramme (14n).

5. Verfahren nach einem der vorangehenden Ansprüche, **dadurch gekennzeichnet, dass** aus der Anzahl gesendeter Datentelegramme innerhalb eines bestimmten Zeitraums n(tx) und der Anzahl tatsächlich empfangener Datentelegramme n(Rx) die aktuelle Paketfehlerrate PER(ist) bestimmt wird, wobei die Veränderung der Anzahl (n') künftiger Sende-Wiederholungen anhand der aktuellen Paketfehlerrate PER(ist) erfolgt.

6. Verfahren nach einem der vorangehenden Ansprüche, **dadurch gekennzeichnet, dass** als Vergleicher (21) eine Vorrichtung innerhalb des Speichers (20) und/oder eine Softwarelösung vorgesehen ist.

7. Verfahren nach einem der vorangehenden Ansprüche, **dadurch gekennzeichnet, dass** es sich beim Übertragungskanal (17) um einen bidirektionalen Übertragungskanal handelt.

8. Verfahren nach einem der vorangehenden Ansprüche, **dadurch gekennzeichnet, dass** es sich bei der Datenquelle (10) um ein Verbrauchszähler zum Bestimmen des Verbrauchs an einem Versorgungsmedium und/oder beim Speicher (20) um einen Datensammler bzw. Datenkonzentrator handelt.

9. Einrichtung zum wiederholten Senden haustechnischer Daten über einen stochastisch gestörten Übertragungskanal (17) in mindestens einem ISM- und/oder SRD-Band mit a priori unbekannter und variierender momentaner Kanalbelegung, ausgelegt zum Ausüben eines der Verfahren gemäß den vorangehenden Verfahrensansprüchen, ausgestattet mit einem Sensor (11) und einem Transceiver (16) bei einer Datenquelle (10) und mit einem Transceiver (19) bei einem Speicher (20), wobei ein Vergleicher (21) beim Speicher (20) vorgesehen ist, der dazu hergerichtet ist, eine Paketfehlerrate (PER) aus dem Verhältnis der Anzahl (m) ungestört empfangener Datentelegramme zur Anzahl (n) während der Zeitspanne gesendeter Datentelegramme (14m/14n) zu ermitteln, wobei die momentane Paketfehlerrate PER(ist) quasi- oder diskontinuierlich für die jeweils aktuell angetroffenen Übertragungsgegebenheiten bestimmt wird, wobei aus der Paketfehlerrate (PER) eine Anzahl (n') künftiger Sende-Wiederholungen hergeleitet wird, damit mit hinreichender Wahrscheinlichkeit ein aktuelles, wiederholt gesendetes Datentelegramm (14) trotz Störeinflüssen, wobei es sich bei den Störeinflüssen um Störungen durch Überlagerung mit anderen Signalen in dem Kanal handelt, im Übertragungskanal (17) korrekt im Speicher (20) erfasst wird, wobei die Anzahl (n') künftiger Sende-Wiederholungen vom Transceiver (19) des Speichers (20) an den Transceiver (16) der Datenquelle (10) gesendet wird und wobei die Vorgabe einer optimalen bzw. gewünschten Paketfehlerrate PER(soll) durch die Veränderung der Anzahl (n') künftiger Sende-Wiederholungen erreicht wird, indem die aktuelle Verlustwahrscheinlichkeit p(ist), welche sich aus der momentanen Paketfehlerrate PER(ist) bestimmt, und die optimale Paketfehlerrate PER(soll) zur Bestimmung der erforderlichen Anzahl an Aussendungen der Datentelegramme bzw. Teiltelegramme n(soll) herangezogen wird.

10. Einrichtung nach Anspruch 9, **dadurch gekennzeichnet, dass** beim Speicher (20) eine Handhabe (22) zum Beeinflussen der künftigen Anzahl (n') von Sendewiederholungen vorgesehen ist.

11. Einrichtung nach Anspruch 9 oder 10 , **dadurch gekennzeichnet, dass** die Handhabe (22) um manuell betätigbar, fernsteuerbar und/oder mittels Software steuerbar ist

**Claims**

1. Method for repeatedly transmitting domestic data in the form of data messages (14n) from a transceiver (16) of a data source (10) to a memory (20) via a transmission channel (17) with stochastic interference in at least one ISM and/or SRD band with a priori unknown and varying instantaneous channel assignment, wherein a packet error rate (PER) is determined in a comparator (21) for the data messages (14m) received over a period as the ratio of data messages received without interference to data messages transmitted during the period (14m/14n), wherein the instantaneous packet error rate PER(actual) is determined quasi-continuously or discontinuously for the respectively current transmission conditions, wherein the number (n') of future repeated transmissions is changed for the purpose of influencing the packet error rate (PER) so that a current, repeatedly transmitted data message (14) is captured correctly in the memory (20) with sufficient probability despite interfering influences in the transmission channel (17), wherein the interfering influences are interference caused by superimposition with other signals in the channel, wherein the number (n') of future repeated transmissions via the transmission channel (17) is stored in the comparator (21) and is transmitted to the transceiver (16) of the data source (10), and wherein the specification of an optimum or desired packet error rate PER(desired) is achieved by changing the number (n') of future repeated transmissions by virtue of the current probability p(actual) of a channel assignment or channel interference, which is determined from the instantaneous packet error rate PER(actual), and the optimum packet error rate PER(desired) being used to determine the required number of emissions of the data messages or partial messages n(desired).

2. Method according to Claim 1, **characterized in that** a battery (23) is provided for the purpose of operating at least the transmitter (15) and/or the sensor (11) of the data source (10), and the number (n') or the frequency of future repeated transmissions is reduced towards the end of the operating period of the battery (23).

3. Method according to one of the preceding claims, **characterized in that** the number (n') of future repeated transmissions is influenced in a program-controlled, remotely controlled or manual manner.

4. Method according to one of the preceding claims, **characterized in that** successive data messages (14n) are each transmitted and received as partial messages, with the replacement of an incorrect partial message with that correct data message from one of the data messages (14n) which have already been repeatedly transmitted and received.

5. Method according to one of the preceding claims, **characterized in that** the current packet error rate PER(actual) is determined from the number of transmitted data messages within a particular period n(tx) and the number of actually received data messages n(Rx), wherein the number (n') of future repeated transmissions is changed on the basis of the current packet error rate PER(actual).

6. Method according to one of the preceding claims, **characterized in that** an apparatus inside the memory (20) and/or a software solution is/are provided as the comparator (21).

7. Method according to one of the preceding claims, **characterized in that** the transmission channel (17) is a bidirectional transmission channel.

8. Method according to one of the preceding claims, **characterized in that** the data source (10) is a consumption meter for determining the consumption of a supply medium, and/or the memory (20) is a data collector or a data concentrator.

9. Device for repeatedly transmitting domestic data via a transmission channel (17) with stochastic interference in at least one ISM and/or SRD band with a priori unknown and varying instantaneous channel assignment, designed to carry out one of the methods according to the preceding method claims, equipped with a sensor (11) and a transceiver (16) in a data source (10) and with a transceiver (19) in a memory (20), wherein a comparator (21) is provided in the memory (20) and is set up to determine a packet error rate (PER) from the ratio of the number (m) of data messages received without interference to the number (n) of data messages transmitted during the period (14m/14n), wherein the instantaneous packet error rate PER(actual) is determined quasi-continuously or discontinuously for the respectively current transmission conditions, wherein a number (n') of future repeated transmissions is derived from the packet error rate (PER) so that a current, repeatedly transmitted data message (14) is captured correctly in the memory (20) with sufficient probability despite interfering influences in the transmission channel (17), wherein the interfering influences are interference caused by superimposition with other signals in the channel, wherein the number (n') of future repeated transmissions is transmitted from the transceiver (19) of the memory (20) to the transceiver (16) of the data source (10), and wherein the specification of an optimum or desired packet error rate PER(desired) is achieved by changing the number (n') of future repeated transmissions by virtue of the current loss probability p(actual), which is determined from the instantaneous packet error rate PER(actual), and the optimum packet error rate PER(desired) being used to determine the required number of emissions of the data messages or partial messages n (desired).

10. Device according to Claim 9, **characterized in that** a handle (22) for influencing the future number (n') of repeated transmissions is provided in the memory (20).

11. Device according to Claim 9 or 10, **characterized in that** the handle (22) can be manually actuated, can be remotely controlled and/or can be controlled by means of software.

**Revendications**

1. Procédé pour l'émission répétée de données domotiques sous la forme de télégrammes de données (14n) depuis un émetteur-récepteur (16) d'une source de données (10) à une mémoire (20) par le biais d'un canal de transmission (17) perturbé de manière stochastique dans au moins une bande ISM et/ou SRD avec une occupation des canaux à priori inconnue et qui varie momentanément, un taux d'erreurs sur les paquets (PER) étant déterminé dans un comparateur (21) pour les télégrammes de données (14m) reçus sur un intervalle de temps sous la forme du rapport entre les télégrammes de données reçus non perturbés et ceux émis pendant l'intervalle de temps (14m/14n), le taux d'erreurs sur les paquets momentané PER(ist) étant déterminé quasi-continuellement ou de manière discontinue pour les conditions de transmission actuelles respectivement rencontrées, le nombre (n') de futures répétitions de l'émission étant modifié en vue d'influencer le taux d'erreurs sur les paquets (PER) afin qu'un télégramme de données (14) actuel émis de manière répétée soit acquis avec une probabilité suffisante dans la mémoire (20) malgré les influences perturbatrices dans le canal de transmission (17), les influences perturbatrices étant des perturbations causées par la superposition avec d'autres signaux dans le canal, le nombre (n') de futures répétitions de l'émission sur le canal de transmission (17) étant stocké dans le comparateur (21) et communiqué à l'émetteur-récepteur (16) de la source de données (10) et la prédéfinition d'un taux d'erreurs sur les paquets optimal PER(soll) ou souhaité étant obtenue en modifiant le nombre (n') de futures répétitions de l'émission, en ce que la probabilité actuelle p(ist) d'une occupation du canal ou d'une perturbation du canal, qui est déterminée à partir du taux d'erreurs sur les paquets momentané PER(ist), et le taux d'erreurs sur les paquets optimal PER(soll) sont utilisés pour la détermination du nombre nécessaire d'émissions des télégrammes de données ou télégrammes partiels n(soll).

2. Procédé selon la revendication 1, **caractérisé en ce qu'**une batterie (23) est présente pour faire fonctionner au moins l'émetteur (15) et/ou le capteur (11) de la source de données (10) et le nombre (n') ou la fréquence des futures répétitions de l'émission est réduit vers la fin de la période opérationnelle de la batterie (23).

3. Procédé selon l'une des revendications précédentes, **caractérisé en ce que** le nombre (n') ou la fréquence des futures répétitions de l'émission est commandé par programme, commande à distance ou influencé manuellement.

4. Procédé selon l'une des revendications précédentes, **caractérisé en ce que** les télégrammes de données (14n) successifs sont respectivement émis et reçus sous la forme de télégrammes partiels, avec remplacement d'un télégramme partiel défectueux par celui qui est correct parmi l'un des télégrammes de données (14n) déjà émis et reçus de manière répétée.

5. Procédé selon l'une des revendications précédentes, **caractérisé en ce que** le taux d'erreurs sur les paquets actuel PER(ist) est déterminé à partir du nombre de télégrammes de données émis au sein d'une période n(tx) déterminée et du nombre de télégrammes de données réellement reçus n(Rx), la modification du nombre (n') de futures répétitions de l'émission étant effectuée à l'aide du taux d'erreurs sur les paquets actuel PER(ist).

6. Procédé selon l'une des revendications précédentes, **caractérisé en ce que** le comparateur (21) présent est un arrangement à l'intérieur de la mémoire (20) et/ou une solution logicielle.

7. Procédé selon l'une des revendications précédentes, **caractérisé en ce que** le canal de transmission (17) est un canal de transmission bidirectionnel.

8. Procédé selon l'une des revendications précédentes, **caractérisé en ce que** la source de données (10) est un compteur de consommation destiné à déterminer la consommation d'un fluide d'alimentation et/ou la mémoire (20) est un collecteur de données ou un concentrateur de données.

9. Dispositif pour l'émission répétée de données domotiques par le biais d'un canal de transmission (17) perturbé de manière stochastique dans au moins une bande ISM et/ou SRD avec une occupation des canaux à priori inconnue et qui varie momentanément, conçu pour mettre en œuvre un procédé selon l'une des revendications précédentes, équipé d'un capteur (11) et d'un émetteur-récepteur (16) au niveau d'une source de données (10) et d'un émetteur-récepteur (19) au niveau d'une mémoire (20), un comparateur (21) étant présent au niveau de la mémoire (20), lequel est conçu pour déterminer un taux d'erreurs sur les paquets (PER) à partir du rapport entre le nombre (m) de télégrammes de données reçus non perturbés et le nombre (n) de télégrammes de données émis pendant l'intervalle de temps (14m/14n), le taux d'erreurs sur les paquets momentané PER(ist) étant déterminé quasi-continuellement ou de manière discontinue pour les conditions de transmission actuelles respectivement rencontrées, un nombre (n') de futures répétitions de l'émission étant dérivé du taux d'erreurs sur les paquets (PER) afin qu'un télégramme de données (14) actuel émis de manière répétée soit acquis avec une probabilité suffisante dans la mémoire (20) malgré les influences perturbatrices dans le canal de transmission (17), les influences perturbatrices étant des perturbations causées par la superposition avec d'autres signaux dans le canal, le nombre (n') de futures répétitions de l'émission par l'émetteur-récepteur (19) de la mémoire (20) à l'émetteur-récepteur (16) de la source de données (10) étant émis et la prédéfinition d'un taux d'erreurs sur les paquets optimal PER(soll) ou souhaité étant obtenue en modifiant le nombre (n') de futures répétitions de l'émission, en ce que la probabilité actuelle p(ist), qui est déterminée à partir du taux d'erreurs sur les paquets momentané PER(ist), et le taux d'erreurs sur les paquets optimal PER(soll) sont utilisés pour la détermination du nombre nécessaire d'émissions des télégrammes de données ou télégrammes partiels n(soll).

10. Dispositif selon la revendication 9, **caractérisé en ce qu'**une poignée (22) est présente au niveau de la mémoire (20) pour influencer le futur nombre (n') d'émissions répétées.

11. Dispositif selon la revendication 9 ou 10, **caractérisé en ce que** la poignée (22) est actionnable manuellement, commandable à distance et/ou commandable au moyen d'un logiciel.

Fig. 1

Fig. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2953275 A1
- WO 2015113664 A1
- US 20120263107 A1
- US 20150373683 A1
- US 20160262109 A1